# EUROPEAN PATENT APPLICATION

(11) **EP 1 329 837 A2**
(43) Date of publication of application: **23.07.2003**
(21) Application number: 03006567.6
(22) Date of filing: 04.09.1996
(51) Int. Cl.: G06K 7/00, G06K 19/07, G06K 19/077, G06K 7/08

(54) **Remotely powered electronic tag and associated exciter/reader and related method**

(30) Priority: 11.10.1995 US 540813
(62) Divisional of application: 96931470.7
(71) Applicant: Motorola, Inc., Schaumburg, Illinois 60196 (US)
(72) Inventor: Geiszler, Theodore Donald, Los Gatos, California, 95030 (US); Walker, Russ, San Jose, California 95129 (US); Fort, Larry W., Mesa, Arizona 85202 (US); Eberhart, Noel, Cupertino, California 95014 (US); Lauro, George, Bedford Village, New York 10506 (US)
(74) Representative: McCormack, Derek James

(57) **Abstract**

A portable communication device comprising a first electrostatic antenna element (T1) and a second electrostatic antenna (T2) element and circuitry (32) which is coupled to the first antenna element and to the second antenna element and which derives operating power from an electrostatic field in the vicinity of the first and second antenna elements.

## Description

### BACKGROUND OF THE INVENTION

### 1. Field of the Invention

The invention relates generally to portable remotely powered communication devices and to systems for powering up and receiving information from such devices, and more particularly, to such devices and systems that employ electrostatic coupling.

### 2. Description of the Related Art

Remotely powered electronic devices and related systems for powering up and receiving stored information from such devices are well known. For example, U.S. Patent No. 4,818,855, issued to Mongeon et al., entitled, Identification System, discloses a remotely powered identification device which derives power from a remote source via one of an electric field or a magnetic field and which transmits stored information back to the source via the other of the electric field or magnetic field. Similarly, U.S. Patent No. 5,009,227, issued to Geiszler et al., entitled, Proximity Detecting Apparatus, discloses a remotely powered device which uses electromagnetic coupling to derive power from a remote source and which uses both electromagnetic and electrostatic coupling to transmit stored data back to the source.

In the earlier systems described above, an electromagnetic mechanism is used to remotely couple the remote device with either one or both of an exciter system and a receiver system. The exciter generates an excitation signal used to power up the device. The receiver receives the signal produced by the remote device. One reason for the use of electromagnetic coupling in prior devices is that it was believed to be more efficient to remotely couple power from an exciter to a device via an electromagnetic field rather than via an electrostatic field. Moreover, it was believed that in order to employ an electrostatic mechanism to couple energy from an exciter to a remote device using a single-plate antenna, relatively high voltage signals were required. However, the ability to emit higher voltage signals for power up often is limited by FCC regulations.

Earlier electromagnetic coupling mechanisms included an oscillator as part of the exciter circuitry and coil antennas mounted on both the exciter circuitry and a tag or other article that embodied the device and contained its electronic circuit. For example, in one earlier system, excitation circuitry is connected to a coil antenna which radiates excitation signals that are picked up by a coil antenna mounted on a tag that contains the electronic circuit. The excitation signals energize the electronic circuit which automatically produces an information carrying signal that is transmitted to the receiver using electromagnetic or electrostatic coupling.

An ongoing objective in the development of remote communication devices and associated exciters/receivers of the general type described above has been to minimize cost and size and to improve efficiency of operation. A problem with the use of electromagnetic coupling between a remote device and either an exciter or a reader has been the additional complexity involved in the manufacture of remote devices that employ a coil antenna. For example, the spiral layout of a typical coil antenna can be more difficult to produce than the simpler layout of an electrostatic antenna which often can be in the form of a straight wire or planar and plate-like. Another problem, explained above, has been the inability to efficiently couple power electrostatically using acceptable voltage levels. As a consequence, electromagnetic coupling generally has been favored over electrostatic coupling.

Thus, there has been a need for a low cost remotely powered communication device that employs electrostatic coupling both for remote power up and for the transmission of information carrying signals. There also has been a need for an improved method and apparatus for coupling electrostatic power up signals to such a device. The present invention meets these needs.

A device which can provide electronic data transfer using capacitive couplings is described in GB-A-2,149,548. This device does not include the novel and inventive features of the device claimed herein.

### SUMMARY OF THE INVENTION

The present invention provides an improved electrostatically coupled communication device and associated methods of operation, methods of manufacture and related exciter/reader systems. In one aspect, the invention provides an electronic communication device which is powered-up by electrostatic signals. The novel device can be relatively inexpensively produced since it employs electrostatic (capacitive) plates for both data transmission and for power-up, and therefore, does not require a magnetic coil.

These and other features and advantages of the invention will become more apparent from the following detailed description of presently preferred embodiments in conjunction with the appended drawings.

### BRIEF DESCRIPTION OF THE DRAWINGS

Figure 1 is a block diagram of an exciter/reader and a remotely powered communication device in accordance with a presently preferred embodiment of the invention;
Figure 2 is a block diagram of an alternative embodiment of an exciter/reader and a remotely powered communication device in which the device has a dedicated data transmission antenna element;
Figures 3A-3B illustrate a test set up used to perform voltage measurements (V), across T1 and T2, in which a T1 terminal was connected to ground potential and load resistance values (R_{L}) represented different possible loads attributable to a different possible integrated circuits connected between the T1 and T2 terminals;
Figure 4A provides a curve which plots voltage across T1 and T2 versus distance away from E1 and E2 over one inch intervals from 1 inch to 8 inches, where T1 and T2 each is rectangular and measures 4 inches by 5 inches;
Figure 4B provides the actual voltage measurements plotted in Figure 4A;
Figure 5A provides a curve which plots voltage across T1 and T2 versus distance away from E1 and E2 over one inch intervals from 1 inch to 8 inches, where T1 and T2 each is rectangular and measures 3 inches by 4 inches;
Figure 5B provides the actual voltage measurements plotted in Figure 5A;
Figure 6A provides a curve which plots voltage across T1 and T2 versus distance away from E1 and E2 over one inch intervals from 1 inch to 8 inches, where T1 and T2 each is rectangular and measures 2 inches by 3 inches;
Figure 6B provides the actual voltage measurements plotted in Figure 6A;
Figure 7A provides a curve which plots voltage across T1 and T2 versus distance away from E1 and E2 over one inch intervals from 1 inch to 8 inches, where T1 and T2 each is rectangular and measures 0.5 inches by 5 inches;
Figure 7B provides the actual voltage measurements plotted in Figure 7A;
Figure 8A is a top elevation view showing the layout of a presently preferred embodiment of the remotely powered communication device of Figure 1;
Figure 8B is a top elevation view showing the layout of an alternative embodiment of the remotely powered communication device of Figure 1;
Figure 8C is a top elevation view showing the layout of a presently preferred embodiment of the remotely powered communication device of Figure 2;
Figure 8D is a top elevation view showing the layout of an alternative embodiment of the remotely powered communication device of Figure 1 in which no substrate is employed;
Figure 8E is a top elevation view showing the layout of an alternative embodiment of the remotely powered communication device of Figure 2 in which no substrate is employed;
Figure 9A-9C are side cross-sectional views of the three different constructions of the devices of Figures 8A-C;
Figure 10 is a top elevation view of an alternative embodiment of a remotely powered communication device in accordance with the invention which includes two pairs of antenna elements;
Figure 11 is a top elevation view of an alternative embodiment of a remotely powered communication device in accordance with the invention which includes four pairs of antenna elements;
Figures 12A-12B show the device of Figure 8A in two different orientations relative to a portion of an array of exciter elements;
Figure 13 is a simplified top elevation view of a portion of an array of fixed exciter elements which includes elongated horizontal exciter elements and elongated vertical elements;
Figure 14A-14C are simplified top elevation views of three more alternative configurations of a portion of an array of commutated exciter elements; Figure 14A shows a horizontal configuration; Figure 14B shows a diagonal configuration; and Figure 14C shows a vertical configuration;
Figure 15 is a simplified top elevation view of yet another alternative commutated exciter array configuration in which two parallel stripes of exciter elements are dynamically swept in a circular pattern; and
Figure 16 is a top elevation view of still another alternative commutated exciter array configuration in which the array is bounded by sensors which detect the motion of a communication device across the array.

### DETAILED DESCRIPTION OF THE PREFERRED EMBODIMENTS

The present invention comprises a novel remotely powered communication device, an associated exciter/reader system and related methods. The following description is presented to enable any person skilled in the art to make and use the invention. Descriptions of specific applications are provided only as examples. Various modifications to the preferred embodiments will be readily apparent to those skilled in the art, and the general principles defined herein may be applied to other embodiments and applications without departing from the spirit and scope of the invention. Thus, the present invention is not intended to be limited to the embodiments shown, but is to be accorded the widest scope consistent with the principles and features disclosed herein.

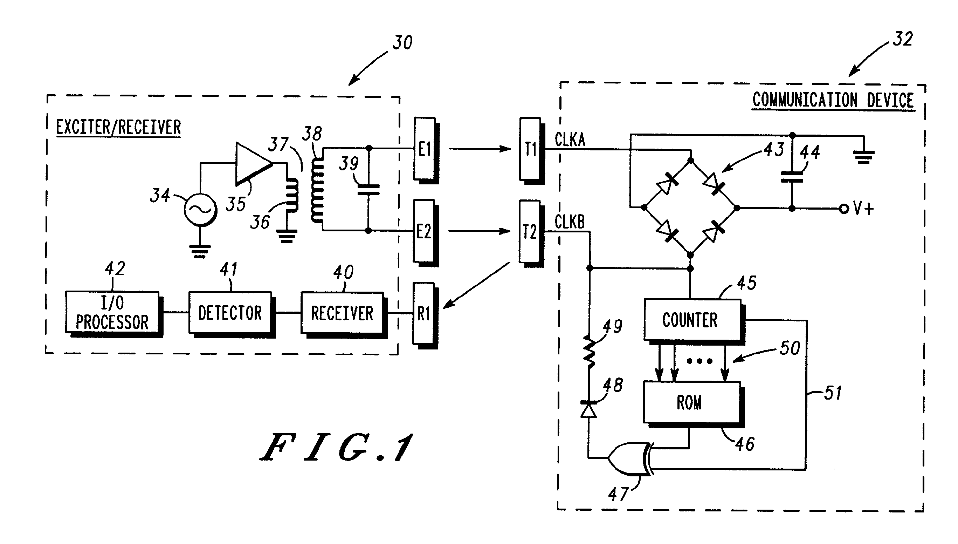

Referring to the illustrative drawings of Figure 1, there is shown a block diagram of an exciter/reader apparatus 30 and a remotely powered communication device 32 in accordance with a presently preferred embodiment of the invention. The exciter portion of the apparatus 30 produces electrostatic signals that are used to power up the device 32. The reader portion of the apparatus 30 receives electrostatic communication signals produced by the device 32 once it has been powered up. The device, for example, can serve as an electronic identification card. In one application, for example, when the device 32 is placed in close proximity to the exciter/reader apparatus 30, the exciter sends electrostatic signals that power up the device 32. The device then automatically transmits an electrostatic signal that carries identifying information. The reader portion of the apparatus 30 receives the identifying signals and determines whether to trigger some action such as the opening of a locked door.

The exciter portion of the apparatus 30 includes an oscillator 34, which generates a signal at frequency F₀. The oscillator is connected to a power amplifier 35 which, in turn, is connected to the primary coil 36 of an impedance transformer 37. A secondary coil 38 of the impedance transformer 37 is connected in parallel with a capacitor 39. A top terminal of the secondary coil 38 is connected to a first electrostatic exciter antenna plate E1, and a bottom terminal of the secondary coil 38 is connected to a second electrostatic exciter antenna plate E2. In a present embodiment, the exciter includes a pair of antenna plates that operate as a balanced out of phase pair. In another embodiment described below, the exciter includes an array of balanced out of phase antenna plates. For the sake of simplicity, however, the following description of Figures 1 discusses only two exemplary exciter plates, E1 and E2. Alternatively, for example, wire antenna exciter elements or a comb-like structure may be employed instead of antenna plates, for example.

The reader portion of the apparatus 30 includes a single-plate electrostatic reader antenna plate R1 connected to a receiver 40 which provides input signals to a detector 41. An I/O processor 42 receives signals from the detector 41.

A current embodiment of the remotely powered communication device 32 includes first and second electrostatic device antenna plates T1 and T2 which are connected as shown to provide clock A and clock B inputs to a full wave bridge rectifier 43. Note that T1 and T2 are electrically isolated from each other. Alternatively, for example, wire antenna elements can be used instead of plates. A capacitor 44 is connected across the V+ and "common" terminals of the rectifier 43. The clock B input is also provided to a frequency dividing counter circuit 45. The counter 45 is connected to provide address signals to a digital storage device, a read only memory (ROM) 46 in a current embodiment. A modulator circuit, in the illustrative embodiment a biphase modulator implemented as an exclusive-or gate 47, receives clock signals, at frequency F₀/n, from the counter 45 and data output from the ROM 46. The output of modulator circuit (the exclusive-or gate 47) is provided via diode 48 and resistor 49 to the clock B line.

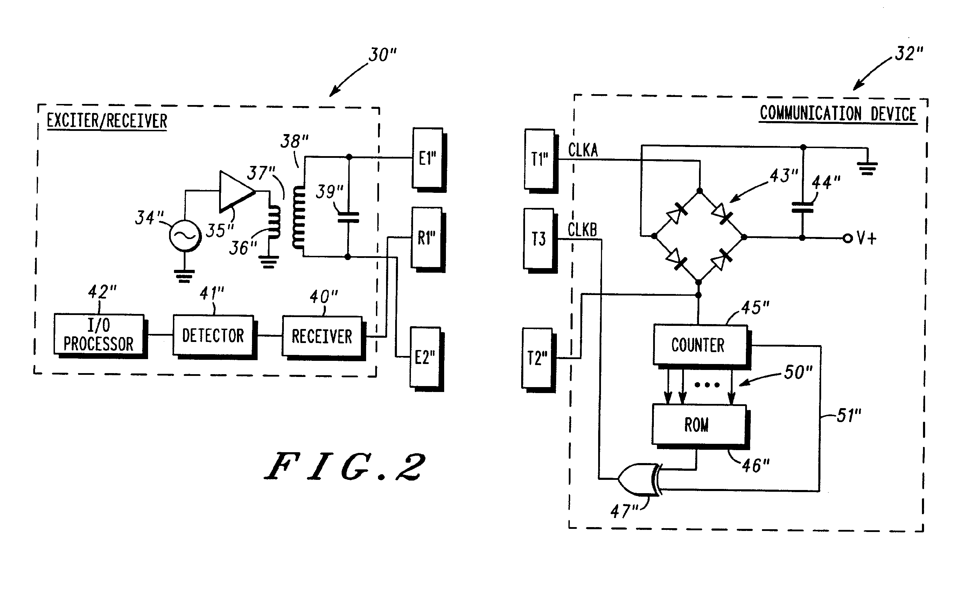

While the device 32 of the presently preferred embodiment employs biphase modulation, virtually any modulation technique can be used consistent with the invention. For example, PSK, FSK, AM or other modulation schemes can be used as alternatives. Moreover, in the current embodiment, the modulated signal is returned to the clock B input for transmission to the reader via antenna plate T2. However, as an alternative for example, the modulated signal could be provided to a separate antenna element (not shown) for transmission to the reader. An alternate embodiment which includes such a separate data transmission antenna element is discussed below with reference to Figure 2.

In operation, the oscillator 34 of a presently preferred embodiment generates a 4 Megahertz signal which is approximately 2-5 volts peak to peak. The signal is boosted to approximately 20-30 volts peak to peak by the amplifier 35. The impedance transformer 37 further boosts the voltage to approximately 300-400 volts peak to peak. The parallel connected capacitor 39 tunes the transformer circuitry to make it resonant at the oscillator frequency. The signal provided to exciter plate E1 via the top terminal of the secondary coil 38 is balanced and 180° out of phase with the signal provided via the bottom terminal of the secondary coil 38 to exciter plate E2. The exciter plates E1 and E2 produce electrostatic energy, indicated by the arrows, which is used to power-up the communication device 32. It will be appreciated that the desired voltage levels of the electric field may depend upon factors such as the distance over which the exciter is to power-up the device 32. Additionally, the desired voltage levels may, for example, depend upon frequency emission requirements of the country in which the exciter will operate. Moreover, certain operations such as writing data into device memory may require more power than other operations such as reading information from device memory.

The electrostatic field produced by the exciter elements E1 and E2 excites voltages on antenna elements T1 and T2. The T1 element is connected to provide the clock A input to the full wave bridge rectifier 43, and the T2 element is connected to provide the clock B input to the rectifier 43. T1 and T2 are not connected directly to each other. The capacitor 44 filters out exciter pulses from the received power up signals to ensure a pure DC output of the rectifier. The rectifier provides a V+ DC voltage signal relative to a "common" terminal of the rectifier 43. It will be appreciated that a pure D.C. signal is not required. Some ripple in the V+ voltage signal may be acceptable depending upon the implementation of the device circuitry. The counter 45 receives the 4 Megahertz clock B signal and provides a set of address signals on lines 50 which are used to address and to set the data rate for the output of data from the ROM 46. The different signals on the different lines 50 are produced by dividing the 4 Megahertz by different values in a manner well known by those skilled in the art. The data rate out of the ROM is significantly less than F₀/n.

It will be understood that although the preferred embodiment uses a 4 Megahertz signal, signals of a different frequency could be used. For example, a 13.56 Megahertz signal or a 37.5 Megahertz signal could be employed.

The counter also provides on line 51 a 2 Megahertz carrier signal which serves as the clock input (or carrier signal input) to the exclusive-or gate 47. The data output of the ROM 46 serves as a data input (or modulation signal input) to the exclusive-or gate 47. The counter, therefore, divides the input frequency by two to provide a carrier signal and sets the data rate of data signals output by the ROM 46 that modulate the carrier. The exclusive-or gate 47 serves as a biphase modulation circuit, and its output is a biphase modulated signal which is provided via diode 48 and resistor 49 to clock B signal line. The biphase signal is injected back onto the T2 device element and is electrostatically transmitted to the receiver portion of the exciter/receiver 30. The role of the diode 48 and the resistor 49 is to couple modulated signals back to the clock B input. As explained above, there are numerous other modulation schemes that use different modulation circuits consistent with the invention. Moreover, as explained below with reference to Figure 2 it can be advantageous to employ a third antenna element dedicated to data transmission on a communication device in accordance with the invention.

The electrostatic receiver antenna R1 receives the electrostatically transmitted signals emitted by device antenna element T2, and provides those received signals to the receiver 40 which amplifies the signals and may convert their frequency to an intermediate frequency for further amplification and bandpass filtering of the signals before providing them to the detector circuit 41 which detects data carried by the received signals. The receiver 40 and the detector 41 are well known circuits which need not be described in detail herein. The detector 41 provides the data signals to the I/O processor 42 which produces an output in a format usable by a host computer (not shown), for example.

The transmission of balanced out of phase electrostatic signals via exciter elements E1 and E2 couples energy to the device 32 via the device electrostatic antenna elements T1 and T2. When the voltage on exciter element E1 is at a positive level, for example, the voltage on element E2 is at a negative level. Conversely, when the voltage on exciter element E1 is at a negative level, the voltage on exciter element E2 is at a positive level. The objective is to have the balanced out of phase voltages on E1 and E2 cause the voltages of device antenna elements T1 and T2 to produce a balanced out of phase relation to each other. The desired result is to always have a voltage potential difference between the device elements, T1 and T2, such that a V+ DC supply voltage source can be produced relative to a "common" potential. In essence, the exciter elements, E1 and E2, are capacitively coupled to the device elements, T1 and T2. This approach permits power to be more efficiently coupled using electrostatic energy.

Moreover, because the exciter antenna elements E1 and E2 produce electrostatic fields that are balanced and out of phase, these fields often tend to cancel each other at farther distances, reducing the risk of exceeding FCC or other regulatory agency emissions limits, for example. As a consequence, the exciter signals often can use higher power up voltage levels.

Instead of using balanced out of phase excitation signals, unbalanced excitation signals can be used as an alternative in accordance with the invention. In particular, for example, a single excitation antenna element could be employed to produce a periodic electrostatic excitation signal. A remotely powered communication device, for example, that was powered up by such an unbalanced signal would include a single antenna element with one terminal connected to a clock A input. It is important, however, that such alternative remotely powered communication device be coupled to an external ground potential. Note that for balanced signals there is no need for an external ground connection since a "common" ground is produced using a clock B input and balanced out of phase signals. In such an alternative embodiment, the single power-up element also could be used to transmit and receive data signals as well.

It is desirable for the device 32 to consume relatively little power. Hence, the information carrying signals transmitted by antenna element T2 are relatively low power. The receiver 40 is highly sensitive and capable of extracting data from the relatively (low power) weak signals transmitted by the device 32.

Note that T1 and T2 are not required to have half wavelength dimensions of a typical electromagnetically excited two element antenna. The elements are electrostatically excited, through capacitive coupling, and need not be resonant as required for electromagnetic coupling. The elements can, therefore, be of an arbitrary size sufficient for capacitive (electrostatic) coupling. In general, capacitive coupling increases with increased antenna area and increased signal frequency. In addition, the device antenna elements need not have a characteristic impedance as do resonant antenna elements. The spacing apart of the exciter antenna elements E1 and E2, however, should be well matched to the spacing of the device antenna elements T1 and T2 in order to efficiently couple energy from the exciter to the device.

Referring to the illustrative drawing of Figure 2, there is shown a simplified block diagram of an alternative embodiment of a communication device 32" and exciter/reader 30" in accordance with the invention. In virtually all respects the alternative device 32" of Figure 2 is identical to the device 32 of Figure 1 except for the addition of a third antenna element (T3) which is used solely for data transmission. Referring to both Figures 1 and 2, the internal circuit connections are identical for device 32 and device 32" except that in device 32", neither T1" nor T2" is connected to receive the output of the data transmission circuitry. Instead, T1" and T2" are dedicated to receipt of the electrostatic power-up field that emanates from the exciter elements E1" and E2". In a current embodiment, T1" and T2" are connected to a bridge circuit 43" and to a counter 45", but there is no connection between the clock A" node or the clock B" node and the output of the data modulation circuitry 47".

The data terminal T3 is disposed in a null region between the power-up terminals T1" and T2". The null position is the place on the device 32" where the power-up fields produced by the exciter elements E1" and E2" substantially cancel each other out, and therefore, produce the minimum amount of interference with data signals transmitted by the device 32". When the device 32" is aligned with T1" and T2" aligned for maximum energy pick-up from exciter elements E1" and E2", the data transmission element T3 will experience minimal interference with transmissions to the reader element R1".

It should be understood that the word "remote" is intended to be a relative term. Depending upon the circumstances, the term, remote, may apply to distances from millimeters to larger ranges. Depending upon factors such as the voltage level of the electrostatic signals radiated by the exciter, the exciter and the device may have to be positioned very close to one another in order to power up the device; or it may be that they can be spaced farther apart and still achieve coupling. The term remote just means that power is coupled over the air from the exciter to the device. It is believed that, in general, increased signal frequency and increased antenna plate area tend to increase the distance over which electrostatic signals can power-up a tag device.

The power-up of the integrated circuit device 32 using electrostatic fields applied over distances such as those achieved in the experiments described with reference to the tables below, is a surprising result. In the past, electrostatic signals had been used to transmit data from a tag device to a reader device. In prior electrostatic data transfers, the data transfer signal often operated at approximately 80% of the power level of the power-up signal used to power-up the earlier tag device. A typical earlier reader had to be highly sensitive, achieving approximately 80-110dB gain, in order to extract data from a carrier signal. In view of the relatively weak electrostatic coupling of data signals in earlier tag devices, it is surprising that electrostatic power-up is achieved, in accordance with the present invention, over the distances tested during the experiments.

Furthermore, there is no apparent electrical current path between antenna elements T1 and T2. Thus, T1 and T2 would appear to constitute opposite sides of an open circuit. Opposite terminals of the bridge circuit 43, therefore, appear to be connected to an open circuit. Thus, it is surprising that power-up is achieved in accordance with the present invention since there appears to be an open circuit applied to the bridge circuit.

More specifically, T1 and T2 are connected to opposed nodes of the bridge circuit 43. Each feeds the same plate of the capacitor 44. Thus, the capacitor plate is a node within the device 32 that is coupled to both T1 and T2. There is no apparent closed circuit, which includes both T1 and T2, and in which current can flow to cause the voltage across capacitor 44. Nevertheless, a sufficient charge build-up across capacitor 44 results from the application of the electrostatic fields by E1 and E2 to produce supply voltage V+ relative to common substrate ground.

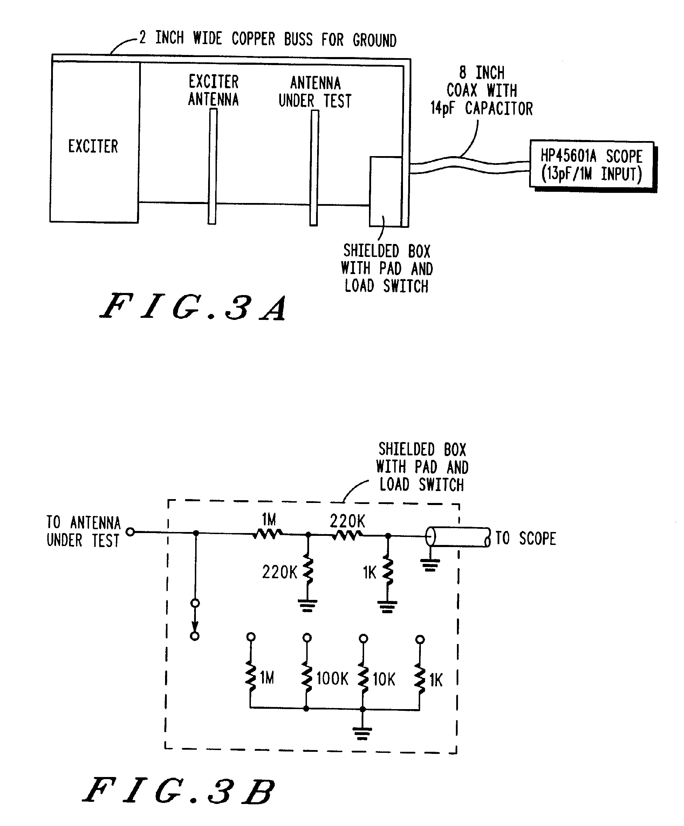

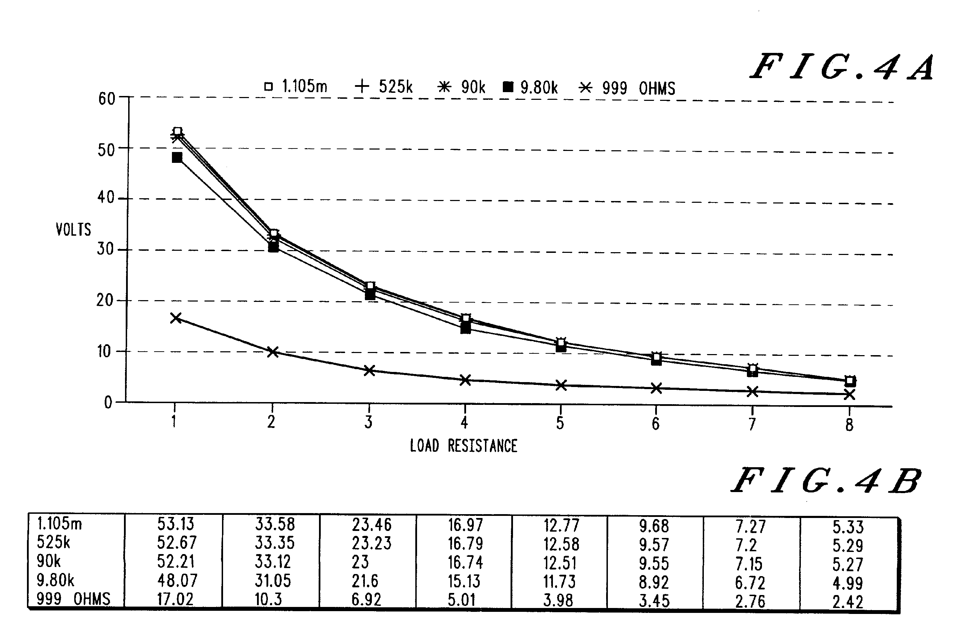

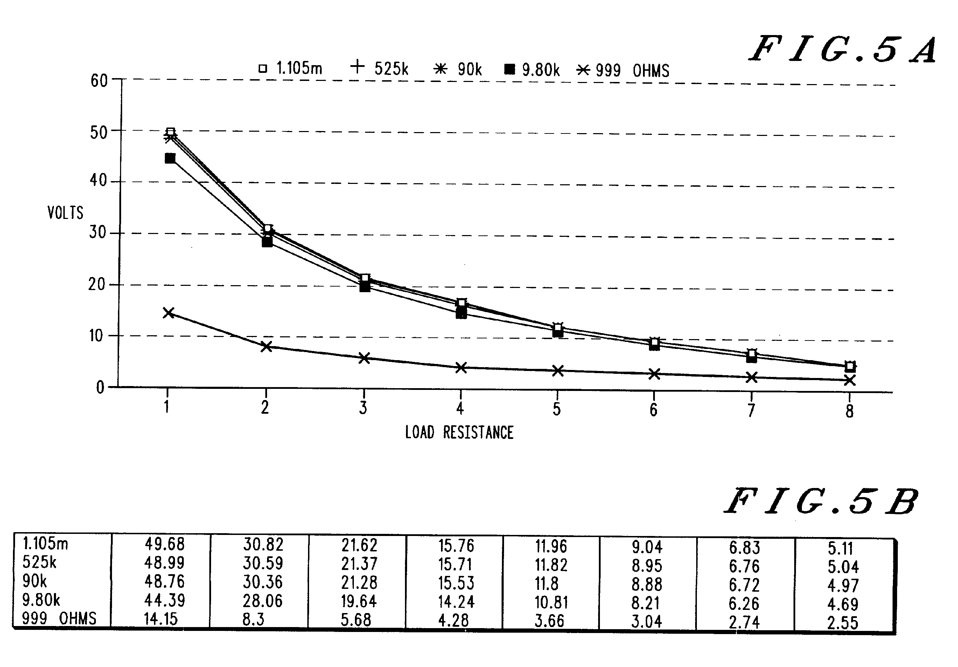

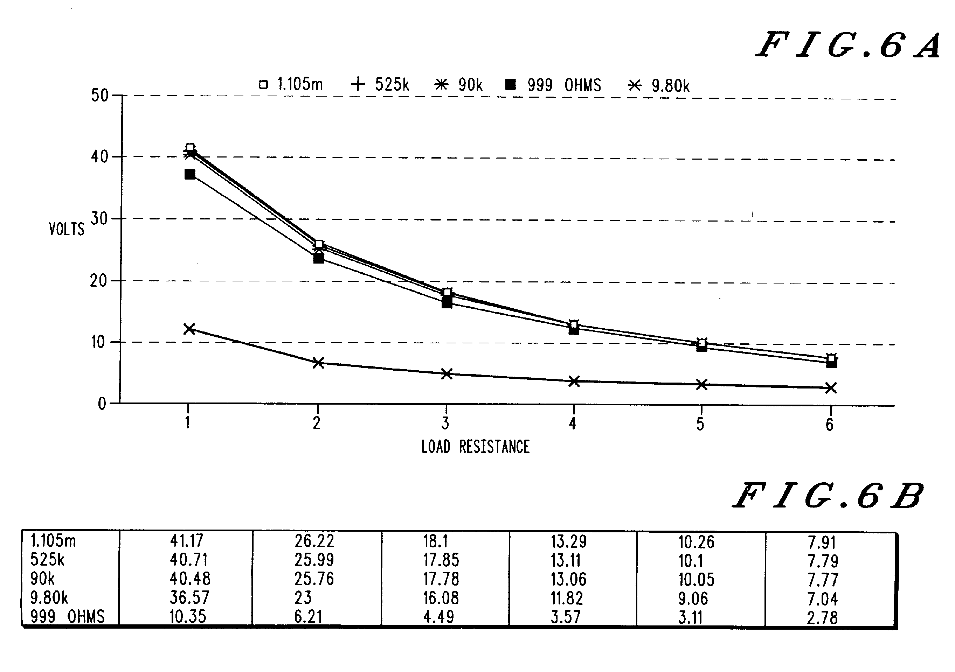

The exemplary test results illustrated in Figures 3-7 demonstrate that electrostatic coupling, in accordance with the invention, can generate sufficient energy to power-up an integrated circuit device. It will be appreciated that power is proportional to V²/R_{L} Figures 3A-3B show the test set up used to perform voltage measurements (V) across T1 and T2. The tests were performed on a tag device in which the T1 terminal was connected to ground potential. The load resistance values (R_{L}) represent different possible loads attributable to a different possible integrated circuits connected between the T1 and T2 terminals. Figure 4A provides a curve which plots voltage across T1 and T2 versus distance away from E1 and E2 over one inch intervals from 1 inch to 8 inches, where T1 and T2 each is rectangular and measures 4 inches by 5 inches. The table in Figure 4B provides the actual voltage measurements plotted in Figure 4A. The curves and tables in Figures 5A-5B, 6A-6B and 7A-7B provide similar measurements for T1s and T2s that measure 3" x 4", 2" x 3" and 0.5" x 5", respectively.

It is believed that the actual power that can be electrostatically coupled in accordance with the invention depends upon distance between the tag device and the exciter, tag device antenna area and signal frequency. An analytical approximation of device behavior has been derived from the empirical results set forth in Figures 3-7 and the supporting specification. The data in Figures 4-7 were imported into a commercially available computer program known as "Mathematica." Two-dimensional curve fitting was performed in order to find a least squares fit starting with a curve that is similar to the expression for a parallel plate capacitance (C = eA/d). The selected starting curve was (V_{d}/Vₓ) = k * (Aₓ * A_{d})^{a} /D^{d} ₓₜ D^{d} ₓₜ; where "k" is a constant; "a" is an area exponent; and "d" is a distance exponent.

A derived equation for voltage coupling between from the exciter to the communication device is:
Vt/Vx = 0.132586((Aₓ*Aₜ)^{0.18}/Dₓₜ, where
Aₓ = exciter antenna element area
A_{d} = communication device antenna element area
V_{d} = device voltage
Vₓ = exciter voltage
Dₓₜ = distance between device and exciter

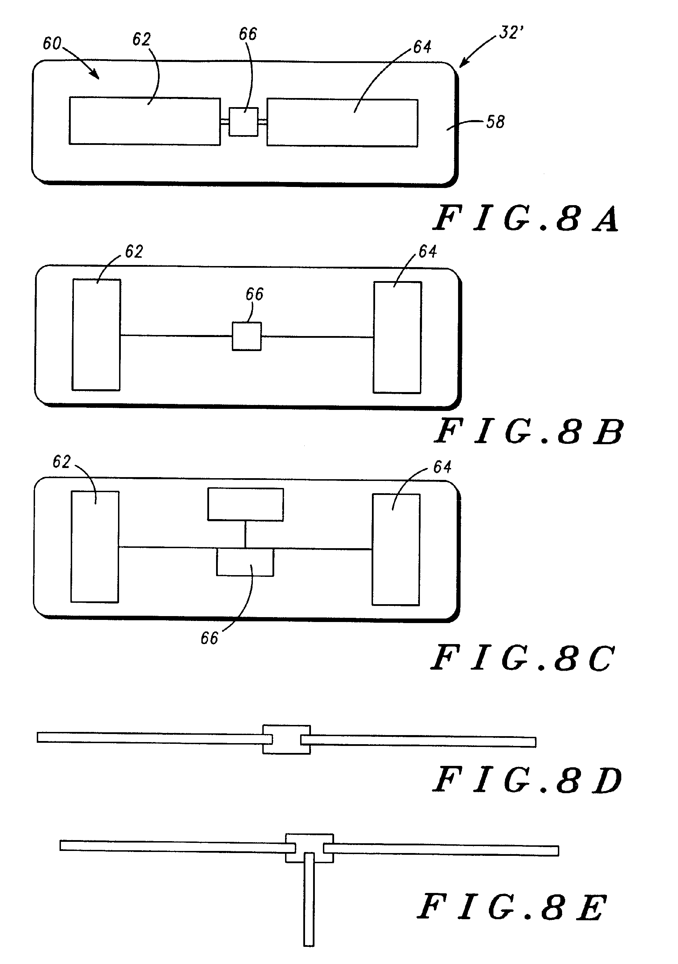

The use of electrostatic coupling both for device power up and for device transmission permits the production of simple and relatively inexpensive remotely powered communication devices. Referring to the illustrative drawing of Figure 8A, there is shown a top elevation view of a presently preferred embodiment of a remote communication device 32 in accordance with the invention. The device 32 includes a substrate 58, a two element antenna 60, which includes a first element 62 (T1) and a second element 64 (T2), and an integrated circuit (IC) transponder 66. The antenna element 60 and the IC 66 are mounted on the substrate 58. The entire device 32 can be encapsulated in a protective structure (not shown) such as plastic or other material. The IC contains the device electronics described above. The first and second elements 62 (T1) and 64 (T2) comprise a conductive pattern formed on the substrate. In a current embodiment, the elements 62 and 64 can be electrically connected to high impedance terminations to pads on the bottom of the IC 66. Since the device 32 operates as a low current device, high impedance terminations can be employed. The two element antenna 60 and the IC 66 can be electrically connected by any of a number of different mechanisms. For example, portions of the plates may be soldered to IC pads; or they may be secured to the pads with a conductive adhesive or by wire connections.

Referring to the illustrative drawings of Figure 8B, there is shown an alternative embodiment of a remote device 32' with an alternate antenna configuration. The antenna elements 62' and 64' are connected to an integrated circuit 66'. The antenna plates and the IC all are disposed on a substrate 58'. The alternative device 32' operates as described with reference to Figure 1. The antenna elements 62' and 64', however, are disposed such that they are maximally spaced apart. That is, their elongated dimensions are substantially parallel to each other and perpendicular to an axis that extends between them and intersects the IC. An advantage of this increased spacing of the device antenna plates is a reduction of the risk of destructive interference between signals emanating from balanced out of phase exciter plates.

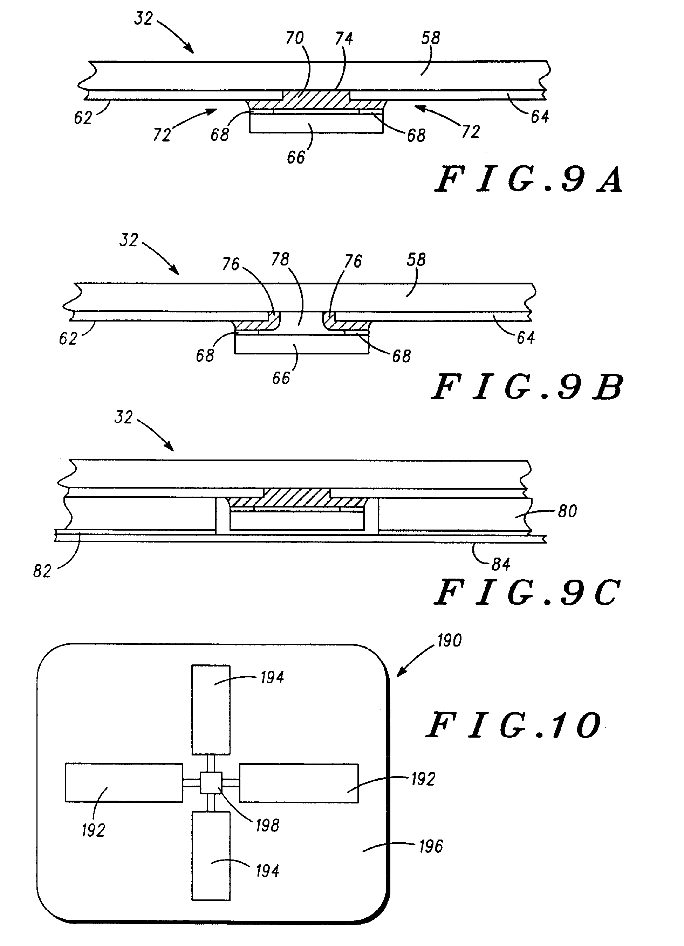

As explained in the following paragraphs, the device 32 (32' or 32") can be produced relatively inexpensively because of the simple layout and construction of the antenna elements 62 and 64. Figures 9A-9C are side cross-sectional drawings of three different constructions of the device of Figure 8A (8B or 8C). Referring to all three Figures 9A-9C, the substrate member 58 can be formed from any suitable material having desired characteristics such as, strength or flexibility, including paper, electrically insulating tape, polyester, polyethylene, polycarbonate, polypropylene, polypropylene with calcium carbonate (CACO₃) filler, plastic, or acetate for example. The antenna elements 62 and 64 are selected from any suitable conductive material such as copper, aluminum, silver or conductive ink containing copper, aluminum, silver, graphite or other conductive fillers for example. The antenna material can be selected based upon factors such as cost and ease of assembly or construction as well as intended usage. The elements can be produced on the substrate by any suitable process such as deposition, printing or etching. For deposition, any process, such as offset printing or roll printing, whereby a layer of (quasi) conductive material is deposited on the substrate can be used. For example, photocopying antenna plate patterns on paper or acetate using carbon loaded ink is possible. Also, vapor deposition of antenna patterns on a substrate is possible. Additionally, for instance, copper antenna elements can be produced using printed circuit board (PCB) manufacturing techniques. There are numerous etching processes such as etched copper, for instance, that can be used to produce antenna patterns on substrates. Furthermore, for example, antenna patterns may be cut from larger sheets of conducting material or hot stamped and adhered to the substrates. The production method can be selected based on factors such as cost, durability and performance of the remote device.

As another alternative, for example, a communication device in accordance with the invention may comprise an integrated circuit plus electrostatic antenna elements which are not disposed on a substrate. Referring to the illustrative drawing of Figures 8D and 8E, there are shown communication devices in accordance with the invention, each of which includes an integrated circuit and electrostatic antenna elements. Neither the device of Figure 8D nor the device of Figure 8E, however, is mounted on a substrate. The integrated circuit of Figure 8D is the general type described above in connection with Figure 1 and is coupled to two electrostatic antenna elements. The integrated circuit of Figure 8E is the general type described above in connection with Figure 2 and is coupled to three electrostatic antenna elements. It will be appreciated that a device, like that in Figures 8D or 8E, in which the IC and antenna elements are not disposed on a substrate at the time of manufacture may, nevertheless, be bonded subsequently to a substrate such as paper or plastic in order to ensure mechanical stability.

A feature of electrostatic coupling is the use of relatively low currents and relatively high voltages when compared with electromagnetic coupling. An advantage of lower currents is that lower conductivity materials can be used for the device antenna plates. This means that materials that are less costly and/or easier to fabricate into antenna plates often can be employed. This can reduce the cost of remotely powered communication devices produced in accordance with the invention.

The IC 66 may have multiple high impedance terminals or pads 68 that are electrically connected to the antenna 60. Each of the antenna elements 62 and 64 of the antenna electrically contacts a different pad. The two plates are kept electrically isolated from each other. In Figure 9A, an anisotropic conductive adhesive 70 such as approximately 40% conductor filler (gold, silver or copper spheres or perhaps graphite for example) is used for the dual purposes of securing the IC to the substrate 58 and providing an electrical connection between the antenna elements 62 and 64 and the IC pads. The anisotropic conductive adhesive 70 conducting in one direction and nonconductive in a direction approximately perpendicular to the conduction path. In a present embodiment, it conducts better along paths in which the adhesive is subjected to greater pressure. In Figure 9A, the anisotropic conductive adhesive is cured under greater pressure in the two narrow regions 72 where it is squeezed between the antenna elements 62 and 64 and the IC pads than in the wider recessed region 74 that separates the two plates between the rest of the IC and the substrate. Hence, there is conduction between each pad and the respective element adhered to it, but there is little or no conduction across the recessed region 74. The elements 62 and 64, therefore, are electrically isolated from each other. An advantage of the use of the anisotropic conductive adhesive 70 is that it need not be applied to the IC pads or to the antenna plates with precision since its conductivity depends upon applied pressure. Therefore, it can be easier to manufacture devices using the anisotropic conductive material because the adhesive can be applied to the active side of an IC or onto the substrate without the concern about overlapping onto other areas. As long as regions of the adhesive that are to be nonconducting are cured under lower pressure than the conductive regions, they will remain nonconducting and will not interfere with the isolation of the two antenna elements.

In Figure 9B, isotropic conductive adhesive 76 such as is used to secure the IC to the substrate 58 and to create an electrical connection between the antenna elements 62 and 64 and the IC pads 68. An isolation material 78 such as solder mask or nonconductive ink or epoxy, is used to electrically isolate different globs of the isotropic conductive adhesive 76 used to adhere the different elements 62 and 64 to different pads 68. The isotropic conductive adhesive conducts equally well in all directions. It must be applied with care so that no conductive path is formed between the two electrically isolated antenna plates.

Figure 9C is similar to Figure 9A except that an intermediate layer of paper or other material 80 is bonded over the antenna plate structure; a layer of adhesive 82 is applied to the intermediate layer 80; and a peel and stick layer 84 is applied over the adhesive layer 82. The device 32 can be adhered or stuck to an object by peeling off the peel and stick layer 84 and pressing the adhesive layer 82 against an object to be identified. Thus, an object can be easily "tagged" with an inexpensive device which can store electronic information about the object.

The object, for example, can be airline luggage. The tag device may have passenger identifying information written into its electronic memory during passenger check-in. The device is stuck to the side of the luggage to identify its owner. When the owner retrieves the luggage, he peels off the tag and discards it.

As explained above, in operation, the two antenna elements 62 (T1) and 64 (T2) must be at different voltages in order to power up the device 32. Specifically, electrostatic coupling for power up requires that a voltage differential (between V+ supply and "common") be set up within the device. In a present embodiment, the voltage differential is established across the two elements 62 and 64 by the balanced out of phase power up signals produced by the exciter. The two antenna elements are connected to a rectifier circuit, a full bridge rectifier in the presently preferred embodiment. A DC voltage is produced between V+ and common. In essence, V+ serves as VDD voltage supply, and common serves as substrate ground for the integrated circuit of the current embodiment.

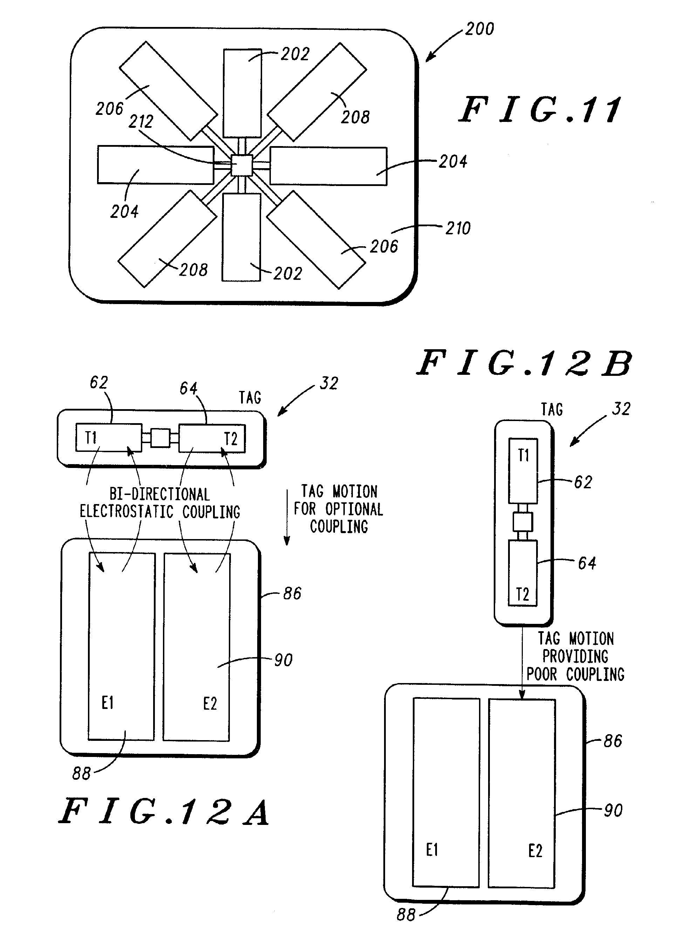

Referring to the illustrative drawings of Figure 10, there is shown a first alternative embodiment of a remote communication device 190 in accordance with the invention. The device includes two pairs of antenna elements 192 and 194 disposed on a substrate 196 and connected to an IC 198 as shown. Referring to Figure 11, there is shown a second alternative embodiment of a remote communication device 200. The device includes four pairs of antenna elements 202-208 disposed on a substrate 210 and connected to an IC 212 as shown.

The manufacture of the devices 190 and 200 can be similar to that of the devices of Figures 9A-C. However, the presence of additional antennas provides greater opportunities for the remote device to align with the exciter plates as will be appreciated from the following discussion. As an alternative to additional device antennas, as explained below, the excitation pattern of an array of exciter plates can be systematically varied in order to produce the greatest likelihood of power up of a remote device regardless of device antenna orientation.

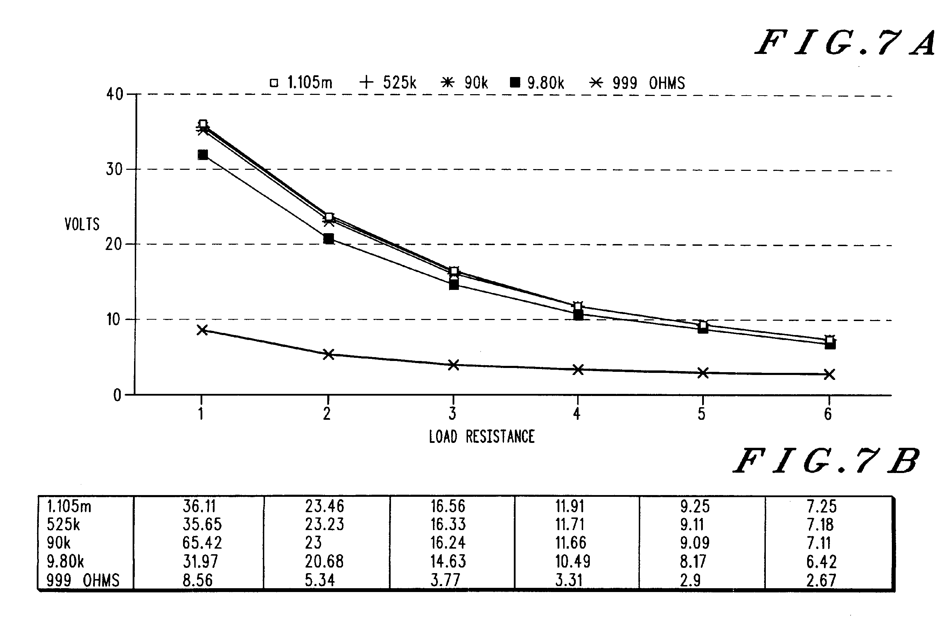

Referring to the illustrative drawings of Figures 12A and 12B, there is shown the device 32 of Figure 3A in two different orientations relative to a portion of an antenna array 86 that can be employed by the exciter/reader apparatus 30. In each of Figures 7A and 7B, the antenna array portion includes a first exciter element 88 (E1) and a second exciter element 90 (E2). The exciter elements 88 (E1) and 90 (E2) have balanced out of phase power up signals applied to them as described above. It should be appreciated that the following discussion applies to the embodiment of Figures 8B and 8C as well.

In Figure 12A, the device 32 has its two antenna elements 62 (T1) and 64 (T2) oriented so that one of the two elements, element 62 (T1), is electrostatically coupled to the exciter element 88 (E1), and the other antenna element 64 (T2) is electrostatically coupled to the second exciter element 90 (E2). Since remote electrostatic coupling is, in essence, capacitive coupling the antenna element 62 (T1) should be positioned opposite (over) the first exciter element 88 (E1) in order for the first exciter element 88 to electrostatically couple its voltage to the element 62 (T1). This positioning is represented in Figure 7A by the curved arrows. Similarly, the device antenna element 64 (T2) should be positioned opposite (over) the second exciter element 90 (E2) to electrostatically couple its voltage to element 64 (T2). It will be appreciated, of course, that it is the voltage differential between the two elements 62 (T1) and 64 (T2) that is important. The voltages on device elements 62 and 64 is dynamic. When the voltage on device element 62 is high, the voltage on device element 64 is low. Thus, it is not essential, for example, that one of the two device elements 62 or 64 be at any particular voltage, such as ground potential, for power up to work. Furthermore, while the above explanation speaks in terms of exciter element 88 (E1) being coupled to device element 62 (T1) and exciter element 90 (E2) being coupled to device element 64 (T2), the invention also works with exciter element 88 (E1) coupled to device element 64 (T2) and with exciter element 90 (E2) coupled to device element 62 (T1).

In Figure 12B, the device 32 is shown oriented relative to the portion of the antenna array 86 such that power up will not be successful. Both of the device elements 62 (T1) and 64 (T2) are opposite (over) the same exciter element 90 (E2). As a consequence, a voltage differential is unlikely to be set up between the two elements 62 (T1) and 64 (T2), and power up is unlikely. Similarly, power up would be impossible if both device elements 62 and 64 were disposed opposite (over) the other exciter element 88 (E1) or if both device elements were positioned equally opposite (over) each of the exciter elements 88 (E1) and 90 (E2). Thus, a challenge in achieving sufficient electrostatic coupling between the device 32 and the exciter/receiver apparatus 30 is to achieve appropriate orientation and positioning of the device elements 62 (T1) and 64 (T2) and the exciter array elements 88 (E1) and 90 (E2). It is, therefore, important that shape, dimensions and spacing between device antenna elements be appropriately matched to the shape dimensions and spacing of the balanced exciter elements. It is not necessary, however, that device antenna element dimensions be the same as exciter element dimensions. For example, an alternative embodiment (not shown) might employ elongated thin device antenna elements excited by wider exciter elements. It has been found that exciter element sizes and shapes may depend, not only upon the size and shape of remote device antenna elements, but also up on the likely trajectory of a device as it passes over an array of exciter elements. As explained below, the required device antenna orientation relative to an array of exciter elements, for example, can be achieved dynamically by electronically changing the relative positioning of the balanced out of phase exciter elements 88 and 90 within the antenna array 86.

In order to achieve the required orientation of device elements and exciter elements, an exciter antenna array in accordance with the invention may comprise either a fixed array or a commutating array of exciter elements. In a fixed array, the relative phasing of voltage signals applied to different exciter elements is fixed. That is, if two exciter elements have a balanced out of phase relation with each other, then that relationship is fixed. In a commutating array, the phase relationships of voltage signals applied to different exciter elements can change. In a commutating array, for example, a controller (not shown) determines the phase relation of the excitation of different antenna elements. For instance, as explained below, in one configuration two adjacent elements may be in a balanced out of phase relationship. However, at a later time, those two elements may operate in phase with each other. In either the fixed or the commutating case, however, the spacing between exciter elements is matched to the spacing between the device antenna elements of a remote communication device. This spacing ensures maximum electrostatic coupling of power from the exciter to the remote device.

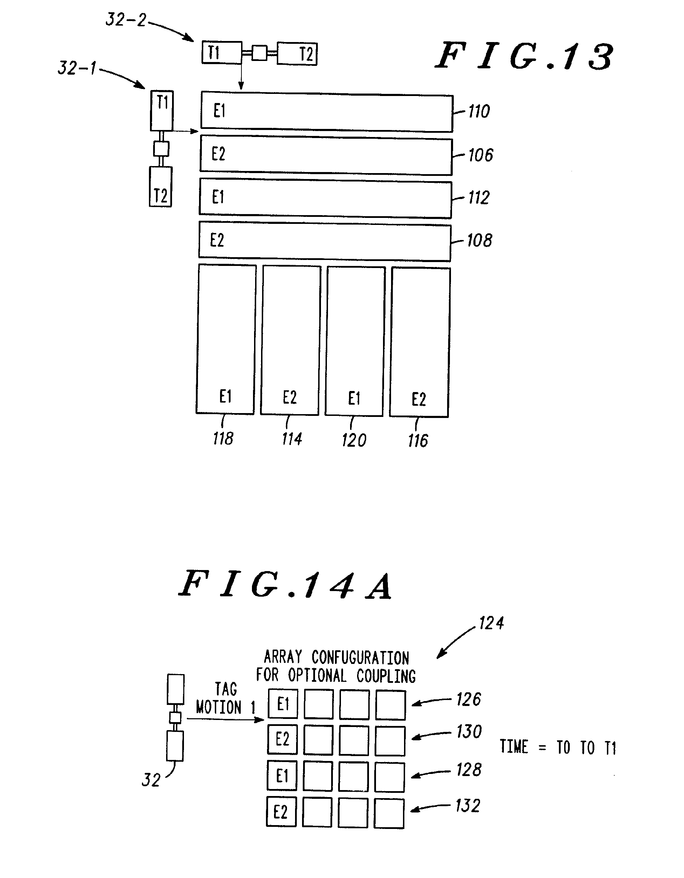

The illustrative drawings of Figure 13 shows a fixed exciter antenna array 100 in accordance with the invention. The array 100 includes a group of elongated horizontal exciter antenna elements 102 and a group of elongated vertical exciter elements 104. Each of the horizontal exciter elements is connected to either the top or the bottom terminal of the secondary coil 38. Similarly, each of the vertical exciter elements is connected to either the top or the bottom terminal of the secondary coil 38. The horizontal exciter elements on either side of any given horizontal exciter element have a balanced out of phase voltage relationship to the given horizontal exciter element. Likewise, the vertical exciter elements on either side of any given vertical exciter element have a balanced out of phase voltage relationship to the given vertical exciter element. For example, if horizontal exciter elements 106 and 108 are connected to the top of the secondary coil, then exciter elements 110 and 112 are connected to the bottom of the secondary coil. Further, for example, if vertical exciter elements 114 and 116 connected to the top of the secondary coil, then vertical exciter elements 118 and 120 are connected to the bottom of the secondary coil. In a presently preferred embodiment, the spacing between adjacent horizontal exciter elements and between adjacent vertical exciter elements is approximately the same as the spacing between the remotely powered communication device elements.

In operation, a first communication device 32-1 is oriented so that its antenna elements will be opposite adjacent horizontal exciter elements as it moved across the face of the antenna array 100 in the direction of the horizontal arrow. Hence, the first device will be oriented for maximal power coupling with the horizontal exciter elements as it horizontally crosses the group of horizontal elements 102. A second device 32-2 is oriented so that its device antenna elements will be opposite adjacent vertical exciter elements as it moves across the face of the antenna array 100 in the direction of the vertical arrow. Thus, the second device will be oriented for maximal power coupling with the vertical exciter elements as it vertically crosses the group of vertical elements 104.

The drawings of Figure 13 represent only a portion of a larger array in which there are numerous groups, 102 and 104, of horizontal and vertical exciter elements oriented as shown. During intervals when a device 32-1 or 32-2 is disposed for maximal power coupling, the device will power up and transmit information. The illustrated grouping of exciter elements seeks to ensure that at some point as device is moved across the exciter antenna array, the device will have sufficient power coupled to it to power up and become operational.

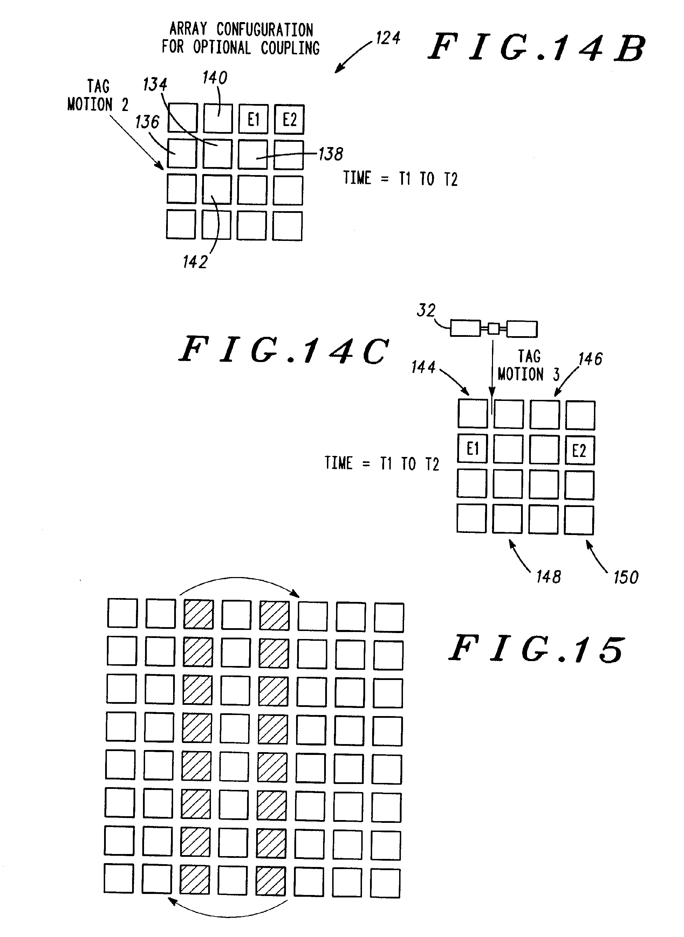

Referring to the illustrative drawings of Figures 14A-14C, there are shown three different configurations of a single portion of a commutated antenna array 124 in accordance with a current embodiment of the invention. Over the course of three time intervals, the array 124 is switched from the horizonal configuration in Figure 14A, to the diagonal configuration in Figure 14B, and finally, to the vertical configuration in Figure 14C. The array consists of a plurality of identically shaped (square in the current embodiment) exciter plates that are arranged in symmetrical rows and columns as shown.

In the horizontal configuration shown in Figure 14A, all of the exciter elements in a given horizontal row share the same voltage phase, and the exciter elements in rows adjacent to the given row all share a balanced out of phase voltage relationship to the given row. That is, the exciter elements in rows 126 and 128 are in balanced out of phase relation with the voltage of the exciter elements in rows 130 and 132. In the horizontal configuration, the array is optimally configured to couple power to a communication device 32 moving across the array in the direction of the horizontal arrow.

In the diagonal configuration shown in Figure 14B, each exciter element in a given row is in a balanced out of phase voltage relation with adjacent exciter elements on either side of it in the same row and with adjacent exciter elements above and below it in the same column. Conversely, each exciter element in a given column is in a balanced out of phase relation with exciter elements above and below it in the same column and with adjacent exciter elements on either side of it in the same row. That is, for example, exciter element 134 is in a balanced out of phase voltage, relation with exciter elements 136 and 138 on either side of it in the same row and with exciter elements 140 and 142 above and below it in the same column. In the diagonal configuration, the array is optimally configured to couple power to a communication device 32 moving diagonally across the array, such as in the direction of the diagonal arrow.

In the vertical configuration shown in Figure 14C, all of the exciter elements in a given vertical column share the same voltage phase, and the exciter elements in columns adjacent to the given column all share a balanced and out of phase relationship relative to the voltage of the given column. That is, the exciter elements in columns 144 and 146 are in a balanced out of phase relation with the exciter plates in columns 148 and 150. In the vertical configuration, the array is optimally configured to couple power to a communication device 32 moving across the array in the direction of the vertical arrow.

Figure 15 illustrates yet another alternative technique for energizing an array of exciter elements. Rather than step through a sequence of horizontal, diagonal and vertical stripes of plates as shown in Figures 14A-14C, a pair of appropriately spaced balanced out of phase stripes 202 and 204 (of individual elements), is swept in a circular pattern across the exciter element array as indicated by the arrows. At some point during the sweep, the antenna elements of a remote device (not shown) disposed sufficiently close to the exciter are likely to be suitably aligned for power up. More specifically, in Figure 15, there is shown a portion of an array 200 of exciter elements. The individual exciter elements of the array 200 are energized such that a plurality of individual exciter elements that comprise the two stripes (shaded) 202 and 204 are in phase with each other but out of phase with other individual (unshaded) exciter elements. The orientation of the two stripes changes with time, but they remain parallel to each other. Thus, for example, in Figure 15 the stripes 202 and 204 are shown vertically oriented. At other times they will be horizontally oriented, and at still other times they will be diagonally oriented. While a pair of balanced out of phase stripes rotating in a circular motion is shown, it will be appreciated that other dynamically changing exciter element patterns and movements can be practiced consistent with the invention.

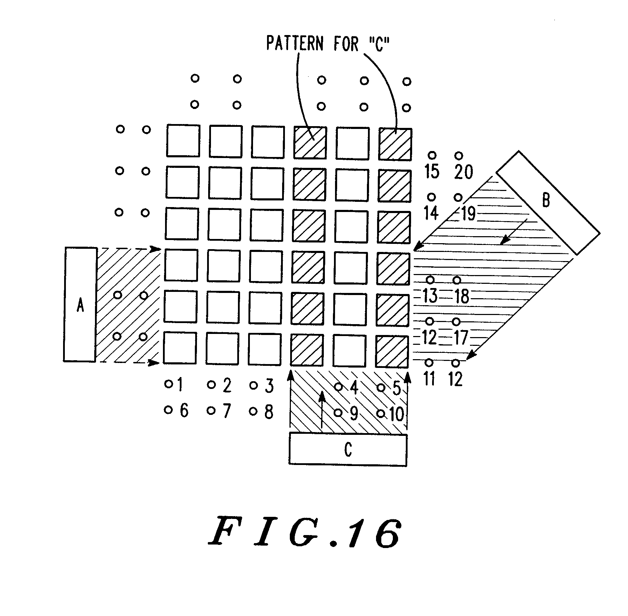

The illustrative drawing of Figure 16 depicts yet another approach to energizing an array of exciter elements in accordance with the invention. In the embodiment of Figure 16, the exciter antenna elements are arranged in an array of rows and columns. An array of sensors, such as optical sensors, are disposed about the periphery of the array of exciter antenna elements. The sensors detect the presence and direction of motion of a communication device, such as device "A" (horizontal), "B"(diagonal) or "C" (vertical). In response to sensor detection of motion, an array controller (not shown) selects an excitation configuration for the array which is likely to couple energy most efficiently to the device as the device passes across the face of the array. For example, depending upon the detected motion of the device, the optimal array configuration may be a horizontal configuration as illustrated in Figure 14A, a diagonal configuration as illustrated in Figure 14B, or a vertical configuration as illustrated in Figure 14C.

While particular embodiments of the invention have been described in detail herein, it will be appreciated that various modifications can be made to the preferred embodiment without departing from the scope of the invention. Thus, the foregoing description is not intended to limit the invention which is defined in the appended claims.

## Claims

**1.** A portable communication device (32) adapted to communicate when operable with a second device (30), the portable communication device being **characterised in that** it comprises:
a circuit (43) coupled to external ground potential and adapted to receive an incoming energising potential for developing a voltage to energise the communication device; and
an antenna element (T1) electrically coupled to the circuit and adapted to receive an energising potential by capacitive coupling with an external source providing an electric field in the vicinity of the antenna element.

**2.** A device according to claim 1 and wherein the electric field is received from the second device and wherein the portable communication device becomes operable by receiving energy when capacitively coupled to the second device.

**4.** A device according to any one of claims 1 to 3 and further comprising a substrate (58), wherein the antenna element (60) is formed on the substrate, and wherein the circuit (66) is secured to the substrate.

**5.** A device according to claim 4 and wherein the substrate is formed of material selected from paper, electrically insulating tape, polyester, polyethylene, polycarbonate, polyproylene, polycarbonate with calcium carbonate filler, acetate and other plastics material, and the antenna element is formed of conducting material selected from copper, aluminium, silver, and conducting ink containing conductive fillers.

**6.** A device according to claim 4 or claim 5 and further comprising a conductive adhesive (70) that secures the circuit to the substrate and that electrically couples the circuit to the antenna element.

**7.** A portable communication device according to any one of the preceding claims and wherein the circuit further comprises:
a memory (46) having stored digital information; and
a signal generator (45) arranged for generating a carrier signal that is modulated based on the stored digital information.

**8.** A device according to any one of the preceding claims and wherein the antenna element (T1) is electrically isolated from ground potential.

**9.** A device according to claim 7 or claim 8 and which includes a second antenna element and wherein the second antenna element (T2) is electrically coupled to the signal generator (45) so as to transmit signals produced by the signal generator.

**10.** A device according to claim 9 and wherein in operation the device includes a circuit portion (45) which accepts an incoming r.f. signal received by the second antenna element (T2).

**11.** A device according to any one of the preceding claims and wherein the device includes a circuit portion (43) which is coupled to two antenna elements (T1, T2) and an external ground potential and is operable to derive a supply voltage from a potential difference between the antenna elements and ground potential.

**12.** A device according to claim 10 or claim 11 and further comprising a substrate on which the first and second antenna elements are disposed and which provides electrical isolation between the first and second antenna elements and the external ground potential.

**13.** A device according to any one of claims 10 to 12 and wherein the circuit is includes a third antenna element.

**14.** A device according to any one of claims 10 to 13 and wherein the device includes first (T1) and second (T2) antenna elements which are connected to first and second nodes of a bridge rectifier circuit (43) having a third node which is connected to ground potential and a fourth node on which an energising rectified potential is in operation produced.

**15.** A device according to claim 14 and wherein the second antenna element (T2) is also connected to a circuit which comprises:
a memory (46) having stored digital information; and
a signal generator (45) arranged for generating using an input signal from the second antenna element a carrier signal that is modulated based on the stored digital information.

**16.** A device according to any one of claims 7 to 15 and wherein the signal generator comprises a clock signal generator (45) providing in operation an output to the memory (46) and outputs from the clock signal generator and the memory are provided in operation to an exclusive OR gate (47) connected to the second antenna (T2) or to a third antenna (T3).

**17.** A capacitively coupled data communication system comprising:
(i) a portable communication device according to any one of the preceding claims; and
(ii) a second device which is an exciter and receiver device comprising an exciter circuit adapted to produce an excitation signal and exciter antennas coupled to the exciter signal and adapted to provide by capacitive coupling to the antenna or antennas of the portable communication device power up of the portable communication device, a receiver antenna element adapted to receive r.f. signals including data signals transmitted by the portable communication device; and a receiver circuit which is coupled to receive signals from the receiver antenna element.

**18.** A capacitively coupled data communication system according to claim 17 and wherein the second device includes an antenna array which includes exciter antenna elements;
a receiver antenna element which receives data signals transmitted by the portable communication device;
a receiver circuit which is coupled to receive data signals received from the receiver antenna element;
a control circuit which selectively connects at least one exciter antenna element of the antenna array to the exciter circuit; and
a plurality of sensors disposed adjacent to the array of exciter antenna elements, the plurality of sensors arranged to detect the presence and direction of motion of the portable communication device, wherein the control circuit is further arranged to selectively connect one or more exciter antenna elements of the array based upon the portable communication device motion sensed by at least one of the plurality of sensors.

**19.** A system according to claim 18 and wherein multiple sensor elements are disposed about a periphery of the array of exciter antenna elements, the multiple sensor elements being arranged to detect the presence and direction of motion of the portable communication device.

**20.** A method for constructing a portable identification device according to any one of the preceding claims, the method comprising the steps of:
providing an electrically insulating carrier;
placing on the electrically insulating carrier an antenna element;
securing a circuit, which comprises first and second terminals, to the electrically insulating carrier; and
electrically coupling the first terminal to the antenna element; and
electrically coupling the second terminal to an external ground potential.

**21.** A method according to claim 20 and wherein the steps of securing and electrically coupling the first terminal involve using a conductive adhesive to secure the circuit to the electrically insulating carrier and to electrically couple the first terminal to the antenna element.

**22.** A method according to claim 20 or claim 21 and wherein the step of placing involves depositing a layer of conductive material onto the electrically insulating carrier.

**23.** A method according to any one of claims 20 to 23 and wherein the second terminal is electrically coupled to the external ground potential via a second antenna element.

**24.** A method of operation of a system according to any one of claims 18 or 19 and comprising the steps of:
at the second device:
generating an r.f.signal on one of the exciter antenna elements; and
transmitting the r.f. signal via the first antenna element and an external
ground potential; and
at the second device:
receiving the r.f. signal from the first antenna element.

**25.** A method according to claim 24 and wherein the step of generating includes the step of generating a carrier signal having a frequency with a range of 25 Hz to 40 MHz.

**26.** A method according to claim 24 or claim 25 and further including the step of orienting the second device such that the device antenna element receives the electric field signal.

**27.** A method according to claim 26 and wherein the step of orienting involves positioning the second device a distance away from the first device in a range from 0.2mm to 50M.

**28.** A method according to any one of claims 24 to 27 and further comprising the step of transmitting data from the first device to the second device via the antenna elements.
